(19) Europäisches Patentamt
European Patent Office
Office européen des brevets

(11) **EP 2 851 962 A1**

(12) **EUROPEAN PATENT APPLICATION**

(43) Date of publication:
**25.03.2015 Bulletin 2015/13**

(51) Int Cl.:
***H01L 31/0352*** *(2006.01)*

(21) Application number: **14185107.1**

(22) Date of filing: **17.09.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **20.09.2013 JP 2013196121**

(71) Applicant: **Kabushiki Kaisha Toshiba**
**Tokyo 105-8001 (JP)**

(72) Inventors:
• **Fujimoto, Akira**
**Tokyo, 105-8001 (JP)**

• **Iwasaki, Takeshi**
**Tokyo, 105-8001 (JP)**
• **Kimura, Kaori**
**Tokyo, 105-8001 (JP)**
• **Takizawa, Kazutaka**
**Tokyo, 105-8001 (JP)**
• **Nakamura, Kenji**
**Tokyo, 105-8001 (JP)**
• **Matake, Shigeru**
**Tokyo, 105-8001 (JP)**

(74) Representative: **Hoffmann Eitle**
**Patent- und Rechtsanwälte PartmbB**
**Arabellastraße 30**
**81925 München (DE)**

(54) **Photoelectric conversion layer and applications thereof to solar cell, photodiode and image sensor**

(57) The present disclosure provides a photoelectric conversion layer containing a semiconductor and plural metal-containing minute structures dispersed therein. The minute structures are minute structures (A) comprising metal material ($\alpha$) or otherwise minute structures (B) comprising metal material ($\alpha$) and material ($\beta$) selected from the group consisting of oxide, nitride and oxynitride of substances and the semiconductor. In the minute structures (B), the material ($\beta$) is on the surface of the metal material ($\alpha$). Each of the minute structures has an equivalent circle diameter of 1 nm to 10 nm inclusive on the basis of the projected area when observed from a particular direction. The closest distance between adjacent two of the minute structures is 3 nm to 50 nm inclusive. The present disclosure also provides applications of the photoelectric conversion layer to a solar cell, a photodiode and an image sensor.

FIG. 1

**Description**

FIELD

Embodiments of the present disclosure relate to a photoelectric conversion layer and applications thereof to a solar cell, a photodiode and an image sensor.

BACKGROUND

An ordinary photoelectric conversion element, which employs a semiconductor, has an absorption wavelength band depending on the band gap of the semiconductor. Further, how much the element can absorb light also depends on the absorptivity of the semiconductor and on the thickness thereof.

For example, a single crystal Si solar cell absorbs light in the wavelength range of 300 to 1100 nm but needs to have several hundreds of microns thickness in order to absorb 100% of the incident light.

Meanwhile, as a means for improving the efficiency of a photoelectric conversion element, a method is proposed in which plasmon resonance is caused by use of a metal nano-structure to generate enhanced electric fields and thereby to propagate carrier excitation. The metal nano-structure is formed on a photoelectric converting part so as to increase the amount of light absorbed in the converting part. However, although the metal nano-structure increases the amount of absorbed light, there is a problem in that light is absorbed in a limited wavelength range and the metal reflects light not a little and consequently the amount of absorbed light is not very increased. As the metal nano-structure, metal-made structures in the shape of nano-rods may be adopted with the aim of absorbing light in a long wavelength range. However, since the major axes of the rods are used to absorb light of long wavelength, there is also a problem in that the metal reflects light not a little to lower the absorption efficiency.

BRIEF DESCRIPTION OF THE DRAWINGS

Figure 1 is a schematic sectional view illustrating a preferred example of the photoelectric conversion layer according to the embodiment.

Figures 2A and 2B schematically illustrate a conventional photoelectric conversion element and photo-absorptivity thereof.

Figures 3A and 3B schematically illustrate a modified conventional photoelectric conversion element and photo-absorptivity thereof.

Figures 4A and 4B schematically illustrate an example of the embodiment and photo-absorptivity thereof.

Figures 5A and 5B schematically illustrate effect of metal-containing minute structures on reduction of light reflection and on enhancement of light absorption.

Figures 6A and 6B schematically illustrate improvement of photoelectric conversion efficiency caused by a preferred photoelectric conversion layer according to the embodiment.

Figures 7A and 7B schematically illustrate a semiconductor and photo-absorptivity thereof.

Figures 8A and 8B schematically illustrate improvement of photo-absorptivity caused by a photoelectric conversion layer according to the embodiment.

Figures 9A and 9B schematically illustrate improvement of photo-absorptivity caused by a photoelectric conversion layer according to the embodiment.

Figures 10A and 10B schematically illustrate a semiconductor and conversion efficiency thereof.

Figures 11A and 11B schematically illustrate improvement of conversion efficiency caused by minute structures in a photoelectric conversion layer according to the embodiment.

Figures 12A and 12B schematically illustrate improvement of conversion efficiency caused by minute structures in a photoelectric conversion layer according to the embodiment.

Figures 13A to 13D show schematic sectional views illustrating a method of producing a photoelectric conversion element according to the embodiment.

Figures 14A to 14D show schematic sectional views illustrating a method of producing a photoelectric conversion element of Example 1 according to the embodiment.

Figures 15A to 15D show schematic sectional views illustrating a method of producing a photoelectric conversion element of Example 2 according to the embodiment.

Figures 16A to 16D show schematic sectional views illustrating a method of producing a photodiode of Example 25 according to the embodiment.

Figures 17A to 17D show schematic sectional views illustrating a method of producing a photodiode of Example 26 according to the embodiment.

Figures 18A to 18D show schematic sectional views illustrating a method of producing a photodiode of Example 29 according to the embodiment.

Figures 19A to 19D show schematic sectional views illustrating a method of producing a photodiode of Example 30 according to the embodiment.

Figures 20A to 20D show schematic sectional views illustrating a method of producing a photoelectric conversion element of Example 17 according to the embodiment.

Figures 21A to 21D show schematic sectional views illustrating a method of producing a photoelectric conversion element of Example 18 according to the embodiment.

DETAILED DESCRIPTION

Embodiments will now be explained with reference to the accompanying drawings.

A photoelectric conversion layer according to the embodiment contains a semiconductor and plural metal-containing minute structures dispersed in said semiconductor, wherein
said metal-containing minute structures are selected from (A) or (B);

(A) metal-containing minute structures comprising metal material;
(B) metal-contaiting minute structures comprising metal material ($\alpha$) and material ($\beta$) selected from the group consisting of oxide, nitride and oxynitride of substances different from either of said metal material ($\alpha$) and said semiconductor, provided that said material ($\beta$) is on the surface of said metal material ($\alpha$); and

each of said metal-containing minute structures has an equivalent circle diameter of 1 nm to 10 nm inclusive on the basis of the projected area when observed from the direction in which said metal-containing minute structures have the smallest projected area in total, and the closest distance between adjacent two of said metal-containing minute structures is 3 nm to 50 nm inclusive.

Here, the projected area of the metal-containing minute structures is determined by use of a TEM image observed from the top-surface side of the layer.

(Photoelectric conversion layer)

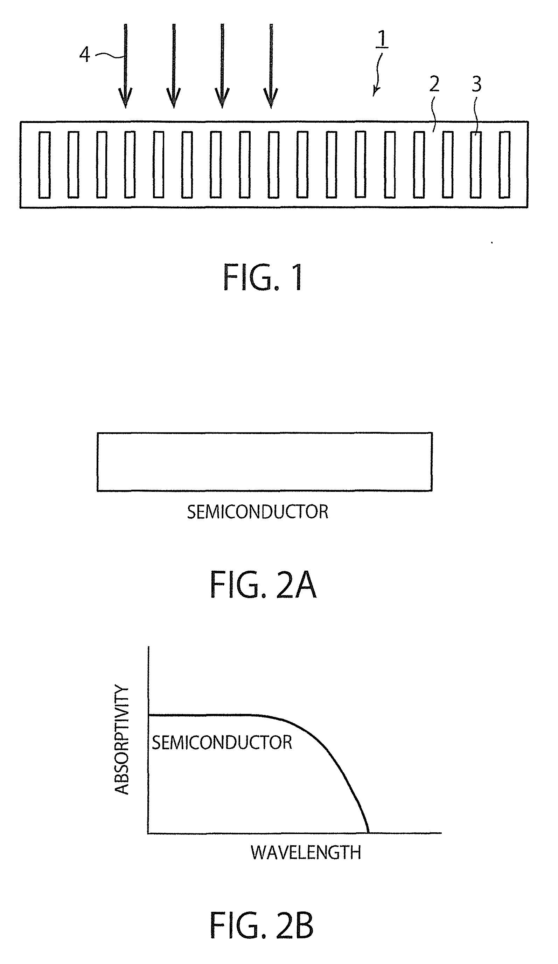

Figure 1 shows an example of the photoelectric conversion layer according to the embodiment. The photoelectric conversion layer of the embodiment shown in Figure 1 is a particularly preferred example in view of the concrete shape and practical applications thereof.

The photoelectric conversion layer 1 in Figure 1 contains a semiconductor 2 and plural metal-containing minute structures 3 dispersed in the semiconductor 2.

The metal-containing minute structures 3 are
metal-containing minute structures (A) comprising metal material ($\alpha$) or otherwise
metal-containing minute structures (B) comprising metal material ($\alpha$) and material ($\beta$) selected from the group consisting of oxide, nitride and oxynitride of substances different from either of the metal material ($\alpha$) and the semiconductor, provided that the material ($\beta$) is on the surface of the metal material ($\alpha$).

Each of the metal-containing minute structures 3 has an equivalent circle diameter of 1 nm to 10 nm inclusive on the basis of the projected area when observed from the direction in which the metal-containing minute structures have the smallest projected area in total, and the closest distance between adjacent two of said metal-containing minute structures is 3 nm to 50 nm inclusive.

Specifically, the photoelectric conversion layer of the embodiment shown in Figure 1 is a tabular photoelectric conversion layer 1 containing a semiconductor 2 and plural rod-shaped metal-containing minute structures 3 dispersed in the semiconductor 2, and the plural rod-shaped metal-containing minute structures 3 are individually oriented along the incident direction of parallel rays 4.

Each of the metal-containing minute structures 3 has an equivalent circle diameter of 1 nm to 10 nm inclusive. The plural metal-containing minute structures 3 may have the same or different equivalent circle diameters. It is preferred that all the plural rod-shaped metal-containing minute structures 3 be oriented essentially in a particular direction, but the embodiment is not limited to that.

As evident from the above, Figure 1 shows only a preferred example of the photoelectric conversion layer according to the embodiment. Accordingly, needless to say, the example shown in Figure 1 by no means restricts the embodiment.

The photoelectric conversion layer, therefore, is not limited to such a tabular layer 1 having a flat surface as is shown in Figure 1, and may have concaves or convexes on the surface. Further, the embodiments also include photoelectric conversion layers in other shapes (such as, spherical shape, cylindrical shape, shapes having polyhedral sections other than the section shown in Figure 1, and so on).

The metal-containing minute structures are not restricted to be in such shape of rods as is shown in Figure 1. The embodiments still also include photoelectric conversion layers containing dot-shaped metal-containing minute structures or containing a mixture of dot-shaped and rod-shaped ones.

In the embodiment, the "equivalent circle diameter" of each metal-containing minute structure is defined under the condition that each structure is "observed from the direction in which the metal-containing minute structures 3 have the smallest projected area in total". This means that the "equivalent circle diameter" of each minute structure is determined by the projected area observed from a particular direction that is determined according to the actual shape of the photoelectric conversion layer. Here the projected area of the metal-containing minute structures is determined by use of a TEM image observed from the top-surface side of the layer.

The photoelectric conversion layer of the embodiment shows photo-absorption intensity that depends on the direction of incident light, but absorbs incident light not only in a particular direction but also in various directions. Accordingly, the conversion layer of the embodiment can absorb incident rays simultaneously coming in plural directions as well as parallel incident rays coming in a particular direction, and further can continuously absorb incident rays in directions changing time-dependently.

When incident light comes into a tabular photo-absorber, it is generally advantageous in view of the photo-energy density per unit area that the incident direction be perpendicular to the surface of the absorber. In Figure 1, the tabular photoelectric conversion layer 1 absorbs incident rays coming perpendicular to the layer. In consideration of the photo-absorbability, it is preferred that the rod-shaped metal-containing minute structures 3 be oriented along the direction of incident light to be absorbed, and therefore they are individually in the posture perpendicular to the surface of the tabular photoelectric conversion layer 1 and dispersed in the semiconductor 2. However, the rod-shaped minute structures 3 may be individually oriented in directions not perpendicular to the surface of the tabular layer 1.

The thickness, size and the like of the photoelectric conversion layer 1 can be properly selected according to the applications, uses, required properties and the like of the conversion layer 1.

The photoelectric conversion layer of the embodiment can contain other materials or substances, which are present in the inside of, for example, a protective film or various optical equipments (not shown) provided on the surface of the layer, the semiconductor 2, the metal material ($\alpha$) or the material ($\beta$), or otherwise are present in the interfaces among them. Examples of those materials or substances include various materials or substances capable or incapable of reacting with the above.

(1) Semiconductor

Preferred examples of the semiconductor constituting the photoelectric conversion layer according to the embodiment include poly-crystal type semiconductors and single crystal type semiconductors.

The semiconductor preferably used in the embodiment is, for example, selected from the group consisting of Si, Ge, SiGe, GaAs, GaP and GaN. Among them, particularly preferred are, for example, semiconductors comprising Si.

The semiconductor has a resistivity of preferably $1 \times 10^{-3}$ to $1 \times 10^{4}$ $(\Omega cm)^{-1}$, further preferably 0.1 to $1 \times 10^{4}$ $(\Omega cm)^{-1}$.

Practically, the semiconductor can be properly selected according to the photoelectric conversion layer and to characteristics and uses of optical devices produced by applying the layer, if necessary, in consideration of combination with the metal-containing minute structures dispersed therein.

For example, in the case where the conversion layer comprising Ag-made minute structures is to be formed for suitable use in a solar cell, Si is a particularly preferred example of the semiconductor.

Further, in the case where the conversion layer comprising Ag-made minute structures is to be formed for suitable use in a photodiode, Si is also a particularly preferred example of the semiconductor.

Still further, in the case where the conversion layer comprising Ag-made minute structures is to be formed for suitable use in an IR image sensor, Ge is a particularly preferred example of the semiconductor.

(2) Metal-containing minute structures

The photoelectric conversion layer of the embodiment contains a semiconductor and plural metal-containing minute structures dispersed therein.

The metal-containing minute structures can be roughly categorized into two types, namely, metal-containing minute structures (A) and metal-containing minute structures (B).

Further, from the viewpoint of the shape, the metal-containing minute structures can be categorized into dot-shaped structures and rod-shaped ones. Either dot-shaped or rod-shaped structures can be exclusively dispersed in the semiconductor or otherwise dot-shaped and rod-shaped structures in mixture can be dispersed in the semiconductor.

The dot-shaped metal-containing minute structures are advantageous because they can be easily formed. On the other hand, the rod-shaped structures are preferred because they have remarkable effect of increasing absorption in a long wavelength range.

The rod-shaped metal-containing minute structures have lengths of preferably 1 nm to 1000 nm inclusive, more preferably 10 nm to 1000 nm inclusive. The aspect ratios (diameter: longitudinal length) thereof are preferably 1:1 to 1:10, more preferably 1:5 to 1:10. The lengths and aspect ratios of the plural rod-shaped minute structures may the same or different from each other.

The dispersion density of the minute structures in the semiconductor does not need to be always constant in the whole semiconductor area, and may be different according to the position. For example, the density of the minute structures in the semiconductor area on the incident-light side can be made thicker than that in the other parts of the area. Further, it is also possible not to disperse the minute structures in a particular semiconductor part on the surface side so that the metal-containing minute structures may not be bared on the semiconductor surface.

(2-1) Metal-containing minute structures (A)

The metal-containing minute structures of one type contained in the photoelectric conversion layer according to the embodiment are "metal-containing minute structures (A) comprising metal material ($\alpha$)".

Preferred examples of the "metal material ($\alpha$)" include Ag, Au, Al, Cu, PdSi, NiSi, PtSi, FeSi$_2$, Cu$_3$Si, PdGe, NiGe, PtGe and Cu$_3$Ge. Among them, Ag is particularly preferred.

For example, in the case where the conversion layer is to be formed for suitable use in a solar cell, Ag is a particularly preferred example of the metal material ($\alpha$).

Further, in the case where the conversion layer is to be formed for suitable use in a photodiode, Ag is a particularly preferred example of the metal material ($\alpha$).

Still further, in the case where the conversion layer is to be formed for suitable use in an IR image sensor, Ag is a particularly preferred example of the metal material ($\alpha$).

(2-2) Metal-containing minute structures (B)

The metal-containing minute structures of the other type contained in the photoelectric conversion layer of the embodiment are "metal-containing minute structures (B) comprising metal material ($\alpha$) and material ($\beta$) selected from the group consisting of oxide, nitride and oxynitride of substances different from either of said metal material ($\alpha$) and said semiconductor, provided that said material ($\beta$) is on the surface of said metal material ($\alpha$)".

Preferred examples of the metal material ($\alpha$) are the same as those described above for the metal-containing minute structures (A). Accordingly, preferred examples of the metal material ($\alpha$) include Ag, Au, Al, Cu, PdSi, NiSi, PtSi, FeSi$_2$, Cu$_3$Si, PdGe, NiGe, PtGe and Cu$_3$Ge. Among them, Ag is particularly preferred.

Preferred examples of the "material ($\beta$) selected from the group consisting of oxide, nitride and oxynitride of substances different from either of said metal material ($\alpha$) and said semiconductor" can be selected from the group consisting of AlOx (where X is 0.5 to 4), SiO$_2$, ZnO, MgO, ZrO, TiO$_2$, ITO, Ta$_2$O$_5$, AlN, AlON, SiN, SiON, PdO and CdO. Among them, Al$_2$O$_3$ is particularly preferred.

As evident from the description of "substances different from either of said metal material ($\alpha$) and said semi-conductor", the material ($\beta$) is not an oxide, nitride or oxynitride of the metal material ($\alpha$) or of the semiconductor contained together with the material ($\beta$) in the photoelectric conversion layer. Accordingly, for example, if the metal material ($\alpha$) is Al, oxides thereof (such as, Al$_2$O$_3$) are not adopted as the material ($\beta$). Similarly, if the semiconductor contains Si, oxides thereof (such as SiO$_3$) are not adopted as the material ($\beta$).

Practically, the metal material ($\alpha$) and the material ($\beta$) can be properly selected in accordance with the photoelectric conversion layer and with characteristics and uses of optical devices produced by applying the layer, if necessary, in consideration of combination with each other and with the semiconductor.

For example, in the case where the conversion layer comprising Ag as the metal material ($\alpha$) is to be formed for suitable use in a solar cell, Al$_2$O$_3$ is a particularly preferred example of the material ($\beta$).

Further, in the case where the conversion layer comprising Ag as the metal material ($\alpha$) is to be formed for suitable use in a photodiode, Al$_2$O$_3$ is a particularly preferred example of the material ($\beta$).

Still further, in the case where the conversion layer comprising Ag as the metal material ($\alpha$) is to be formed for suitable use in an IR image sensor, Al$_2$O$_3$ is a particularly preferred example of the material ($\beta$).

The "metal-containing minute structures (B)" comprise the material ($\beta$) in an amount of preferably 10 to 90 wt% inclusive, more preferably 20 to 50 wt% inclusive based on the total weight of the metal material ($\alpha$) and the material ($\beta$). If the amount of the material ($\beta$) is in the above range, remarkable effect is observed on prevention of photovoltaic current loss at the interface between the metal-containing minute structure and the semiconductor. If the material ($\beta$) is contained in an amount of 10 wt% or more, the effect is insufficient on prevention of loss at the interface. On the other hand, if the amount is more than 90 wt%, the area where the semiconductor is in contact with the metal is so small that MILC (metal induced lateral crystallization) hardly proceeds from the metal crystal faces serving as nuclei. That is unfavorable. Here, the amount of the material (β) can be determined by TEM observation and EDX composition analysis. In the embodiment, the amount of the material (β) in the photoelectric conversion layer is practically regulated on the basis of EDX composition analysis.

The material (β) is on the surface of the metal material (α). Here, the "is on" means that the material (β) is at least in point-contact with the surface of the metal material (α). Accordingly, the material (β) may be in contact with a partial area of the surface of the metal material (α), or otherwise the material (β) may be in contact with essentially the whole surface of the metal material (α) (in other words, the whole surface of the metal material (α) may be covered with the material (β)). Those are also included in the embodiments.

Since the material (β) is on the surface of the metal material (α) in the metal-containing minute structures (B), the metal crystal faces serving as nuclei of MILC are decreased and accordingly nucleation is reduced. Consequently, it is confirmed that the crystal grains grow larger to enhance the orientation ((111)face in this case). The concentration of p-type carriers thus decreases to the order of $1 \times 10^{16}$ cm$^{-3}$ in the poly-crystal semiconductor, and it is therefore presumed that carriers generated by exposure to light have long lifetime and less undergo deactivation.

(2-3) Equivalent circle diameter of metal-containing minute structure

In the photoelectric conversion layer of the embodiment, each of the metal-containing minute structures needs to have an equivalent circle diameter of 1 nm to 10 nm inclusive when observed from the direction in which the metal-containing minute structures have the smallest projected area in total.

If the metal-containing minute structures are too small in size, they are regarded as metal atoms or ions rather than minute structures and hence cannot function as metal inducing electric field-enhancement effect for increasing photo-absorption. In view of that, they are preferably large and accordingly the equivalent circle diameter is generally 1 nm or more, preferably 2 nm or more.

On the other hand, in view of the reflection, they are preferably small and accordingly the equivalent circle diameter is generally 10 nm or less, preferably 8 nm or less, further preferably 5 nm or less.

Here, the equivalent circle diameter can be calculated according to the following formula (1):

$$\text{Equivalent circle diameter} = 2 \times (\text{area of metal-containing minute structure}/\pi)^{1/2}.$$

If the metal-containing minute structures are in the shape of dots, the maximum diameter of each dot-shaped minute structure almost corresponds to each equivalent circle diameter when the layer is observed from the incident parallel light direction in which the metal-containing minute structures have the smallest projected area in total.

If the metal-containing minute structures are in the shape of rods, the maximum diameter of the cross section of each rod-shaped minute structure almost corresponds to each equivalent circle diameter when the layer is observed from the incident parallel light direction in which the metal-containing minute structures have the smallest projected area in total.

In the case where there are some directions "in which the metal-containing minute structures have the smallest projected area in total" (for example, typically in the case where the equivalent circle diameter is the same and the smallest whether such a tabular conversion layer 1 as is shown in Figure 1 is observed perpendicularly from just above the layer or from just under the layer), the layer can be regarded as a photoelectric conversion layer of the embodiment if the conditions are satisfied in one of those directions.

(2-4) Other conditions of metal-containing minute structure

The layer of the embodiment can be further improved in performance as a photoelectric conversion layer by further optimizing the equivalent circle diameter of the metal-containing minute structure, and if necessary, by controlling the closest distance, dispersion density and occupied area of the dispersed metal-containing minute structures.

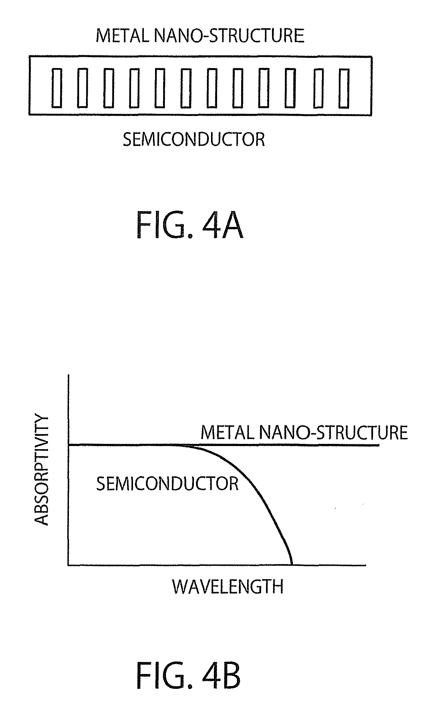

For example, if each metal-containing minute structure has an equivalent circle diameter of 1 to 10 nm inclusive and if the closest distance between adjacent two of the metal-containing minute structures is 3 nm to 50 nm inclusive, it is possible to remarkably increase the amount of photo-energy capable of being absorbed by the semiconductor and of being used effectively. Specifically, as shown in Figures 2 and 4(b), the photoelectric conversion layer of the embodiment can absorb light in a longer wavelength range (namely, can expand the absorbable light wavelength into a longer wavelength range) and accordingly can increase the total amount of photo-energy capable of being absorbed by the layer and of being used effectively. Thus, the performance of the photoelectric conversion layer can be remarkably improved. Actually, the photoelectric conversion layer of the embodiment can increase the absorptivities of light at 1000 nm and at 1500 nm by 50% or more and by 100% or more, respectively, as compared with a semiconductor not equipped with the above metal-containing minute structures.

That is presumed to be because the metal-containing minute structures increase the amount of absorbed light in the absorption band range of the semiconductor without reflecting light and further because light out of the absorption band range of the semiconductor is also absorbed in a considerable amount. In the absorption band wavelength range of the metal-containing minute structures in themselves, the light absorption is increased by the plasmon effect. At the same time, since the semiconductor has electrical conductivity, it is presumed that light in a longer wavelength range can be also absorbed because of the electrical conduction.

The closest distance among the metal-containing minute structures is preferably 3 nm to 50 nm inclusive, more preferably 3 nm to 10 nm inclusive.

Here, the "closest distance among the metal-containing minute structures" means the shortest length of the area or space between adjacent two of the minute structures. This distance is three-dimensionally determined in consideration of difference of positions in the lateral, longitudinal and depth directions between adjacent two of the minute structures.

If each metal-containing minute structure has an equivalent circle diameter of 1 nm to 10 nm inclusive and if the total projected area of the minute structures is in the range of 5 to 50% inclusive based on the projected area of the whole photoelectric conversion layer, the above effect of expanding the absorbable light wavelength is remarkably enhanced.

When the total projected area of the minute structures is in the range of 5 to 50% inclusive based on the whole projected area, the photoelectric conversion layer contains the semiconductor and the metal-containing minute structures in such an optimal ratio as to obtain a synergistic effect based on combination of the photo-absorption effect mainly provided by the semiconductor, the photo-absorption promoting effect mainly provided by the metal-containing minute structures and the effect of reducing unfavorable light-reflection caused mainly by the metal-containing minute structures. As a result, in the case where the projected area of the minute structures occupies 5 to 50% of the whole projected area, the sunlight absorptivity can be improved by 5 to 100% as compared with other cases.

The total projected area of the metal-containing minute structures is in the range of preferably 5 to 50% inclusive, more preferably 30 to 50% inclusive based on the projected area of the whole photoelectric conversion layer.

<Embodiments>

The embodiments will be described below, if necessary, with reference to the attached drawings.

First, the principle of photo-absorption by the semiconductor in the photoelectric conversion layer of the embodiment is explained below by referring to Figures 2 to 4, which show photo-absorptivities of the semiconductors in conventional photoelectric conversion layers and in a photoelectric conversion layer of the embodiment.

(Conventional example 1)

Figure 2 shows photo-absorptivity of a conventional photoelectric conversion element serving as, for example, a single crystal Si solar cell. In Figure 2, the wavelength of light and the photo-absorptivity are plotted on the horizontal and vertical axes, respectively. The photo-absorptivity of the semiconductor in a conventional conversion element depends on the band gap of the semiconductor. For example, since Si has a band gap: $Eg=1.1$ eV, the semiconductor absorbs light in the wavelength range of 1100 nm or less. Accordingly, if having a sufficient thickness, the conversion element exhibits the characteristics shown in Figure 2.

(Conventional example 2)

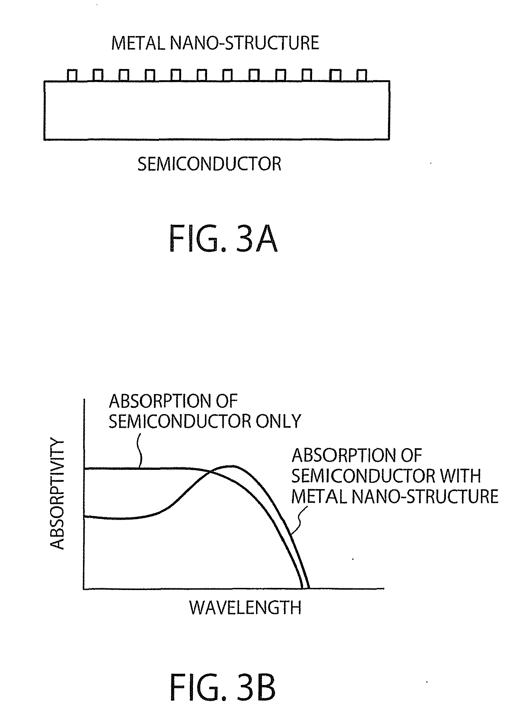

The photoelectric conversion element shown in Figure 3 comprises a metal nano-structure (in the shape of dots or mesh) formed on a semiconductor layer, so as to increase the amount of light absorbed by the semiconductor. If thus provided on the semiconductor, the metal nano-structure can function to cause plasmon resonance so as to generate enhanced electric fields and thereby to propagate carrier excitation. The plasmon resonance increases the amount of absorbed light in a particular wavelength range. However, the plasmon resonance wavelength is limited in a particular range, and accordingly the wavelength of the absorbed light is limited in a particular range. Further, the metal in itself reflects light not a little to decrease the amount of light coming into the semiconductor side at a particular wavelength, and consequently there is a problem in that the amount of absorbed light is not very increased.

(Embodiment)

In order to solve the above problem, the applicant has found that such dot- or rod-shaped very minute metal structures formed in a semiconductor as are shown in Figure 4 make the semiconductor absorb light in a wider wavelength range almost without the metal in itself reflecting the light. Specifically, the applicant has found that, if the metal-containing minute structures have sizes of 10 nm or less when observed from the light-incident side and also have intervals of 3 nm or more among them, the amount of absorbed light in the absorption band range of the semiconductor is increased without the metal causing reflection and further light out of the absorption band range of the semiconductor is also absorbed in a considerable amount.

(Photo-absorption and electrical conductivity)

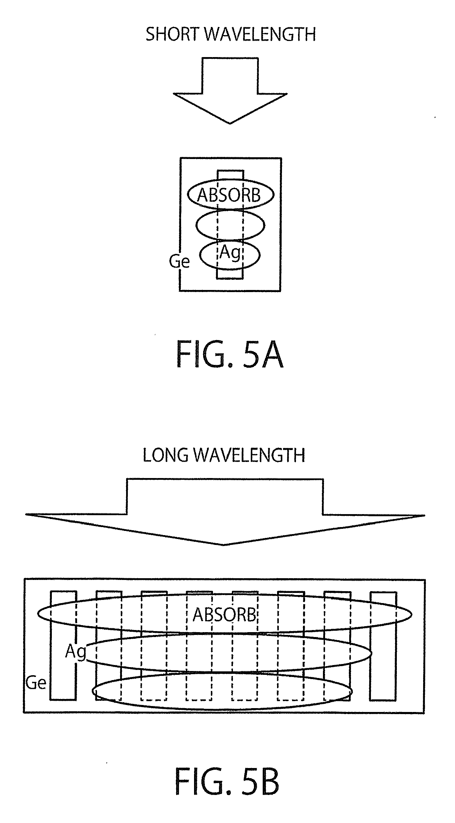

As described above, if the semiconductor layer contains very minute metal nano-structures, the photo-absorption is increased in a wide wavelength range without the metal reflecting light. That is explained by referring to Figure 5. The reason why the metal hardly reflects light is thought to be firstly because the metal nano-structures are buried in the semiconductor and hence the refractive index around them is uniform and well-matched to reduce the reflection and secondly because the metal nano-structures seen from the light-incident side have such small sizes that the incident light does not regard them as reflectors. Accordingly, the sizes of the metal structures are thought to be 10 nm at most. However, if the metal structures are too small in size, they are regarded as metal atoms or ions rather than minute structures and hence cannot function as metal inducing electric field-enhancement effect for increasing photo-absorption. They, hence, need to have sizes of 1 nm or more. Further, if the nano-structures are positioned too close together, the incident light regards them as a continuous one-body structure and hence is reflected. That is unfavorable. The reflection relates to electric field expansion from a metal nano-structure, and the expansion is about 1 nm or less. In consideration of that, if the nano-structures have intervals of 3 nm or more, the electric fields individually expanded from the nano-structures do not overlap with each other and accordingly the reflection can be avoided. The metal nano-structures having large intervals thus do not cause the problem of reflection. However, if arranged in too large intervals, the metal nano-structures occupy such a small area as to weaken the effect. The interval is, therefore, preferably 50 nm or less, and more preferably 10 nm or less for improving the efficiency. In terms of the area occupied by the nano-structures, the above means that the nano-structures preferably have a share of 5 to 50% when observed from the light incident side.

Next, it is explained below how the amount of absorbed light is increased in a wide wavelength range.

As shown in Figure 5, light in a short wavelength range around the visible region is absorbed by the action of one metal nano-structure to increase the amount of absorbed light. In contrast, however, it is presumed that light in a long wavelength range is absorbed by the action of a series of plural metal nano-structures cooperatively functioning according to the wavelength by way of electrical conduction of the semiconductor. Accordingly, the higher electrical conductivity the semiconductor has, the more efficiently light is absorbed in a long wavelength range. Light of a wavelength longer than the absorption band of the semiconductor is presumed to be absorbed only by the metal nano-structures. Since metals generally have constant photo-absorptivities in the IR region, the amount of absorbed light is thought to depend on the electrical conductivity of the semiconductor. If the semiconductor has sufficiently high electrical conductivity, the amount of absorbed light is constant. The higher electrical conductivity the semiconductor has, the more preferred it is. Accordingly, there are no particular restrictions on the upper limit of the electrical conductivity. However, from the practical viewpoint, the upper limit is about $1 \times 10^4$ $(\Omega cm)^{-1}$. If the electrical conductivity is lowered, the absorption is reduced in a long wavelength range. However, for absorbing light of several to several tens of microns wavelength, it is enough for the conduction distance to be a length similar to that. Accordingly, as long as the conductivity is $1 \times 10^{-2}$ $(\Omega cm)^{-1}$ or more, namely, as long as the resistance loss is enough small, there is no problem on the conductivity. Further, for absorbing light of several microns or shorter wavelength, it is enough for the conductivity to be $1 \times 10^{-3}$ $(\Omega cm)^{-1}$ or more.

(Improvement of photoelectric conversion efficiency)

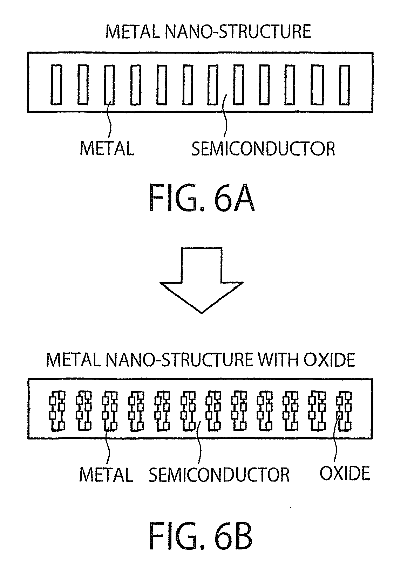

Improvement of the photoelectric conversion efficiency is then explained below by referring to Figure 6. If the metal is in contact with the semiconductor, many interface states are generated at the interface. Those interface states capture and deactivate carries formed by exposure to light. Accordingly, if there are too many areas where the metal is directly in contact with the semiconductor, photovoltaic currents generated by absorption of light are decreased to lower the conversion efficiency. For the purpose of avoiding that problem, an oxide, nitride or oxynitride is inserted between the semiconductor and the metal nano- structures so as to reduce the contact areas. In order to obtain the effect, it is enough for the amount thereof to be 10% or more. That is already known. Examples thereof include $AlO_x$ (where X is 0.5 to 4), $SiO_2$, ZnO, MgO, ZrO, $TiO_2$, ITO, $Ta_2O_5$, AlN, AlON, SiN, SiON, PdO and CdO.

The metal nano-structures are practically formed in the semiconductor by use of semiconductor-metal alloy phase separation according to the vapor-deposition method, the sputtering method or the like. Immediately after a layer of the semiconductor is formed, the semiconductor is mostly in amorphous state. Although the layer can be directly adopted as the photoelectric conversion layer, the semiconductor needs to have higher electrical conductivity so as to absorb light of long wavelength in a large amount. The semiconductor is, therefore, poly-crystallized (or single crystallized) by annealing. That crystallization proceeds according to MILC (metal induced lateral crystallization) from the metal crystal faces serving as nuclei. The above crystallization has the advantage of proceeding at lower temperature than normal solid phase growth of the semiconductor. On the other hand, however, it does not proceed unless the metal is in contact with the semiconductor. Accordingly, the oxide, nitride or oxynitride is incorporated in an amount of preferably 90% or less. Further, if the oxide, nitride or oxynitride is on the metal nano-structure surfaces serving as semiconductor-metal alloy phase separation films, the metal crystal faces serving as nuclei in MILC are decreased to reduce the generation of nuclei. As a result, it can be seen that crystal grains grow largely and are strongly oriented in a particular face, and therefore the semiconductor layer have such improved characteristics that the carriers have long lifetime and less undergo deactivation.

<Embodiment>

The photoelectric conversion layer according to the embodiment is explained in the following description.

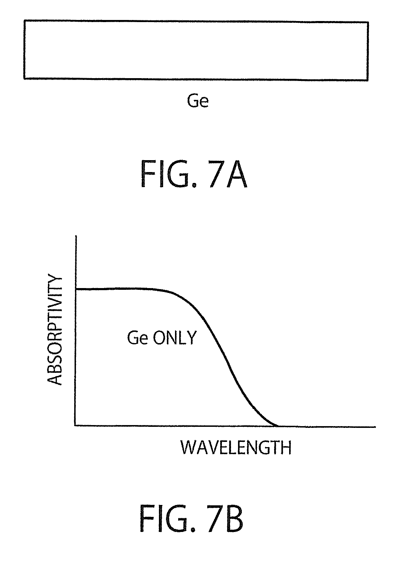

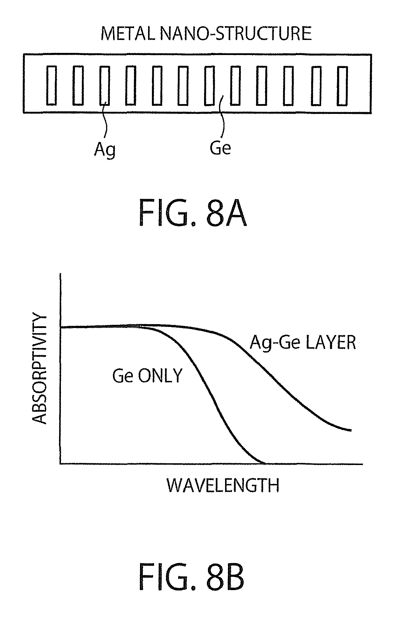

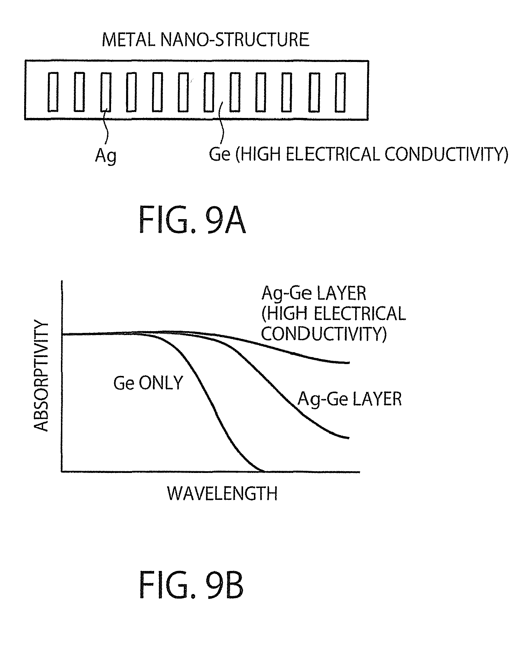

First, the relation between the absorptivity and the wavelength of light is described by referring to Figures 7, 8 and 9 in the cases where the electrical conductivity of Ge or that of Ag rods in Ge is changed. In all the cases, the thickness of the layer is 100 nm in common. Figure 7 illustrates the absorptivity when the layer comprises only Ge. As shown in Figure 7, light is absorbed at 100% in a short wavelength range but the absorptivity largely decreases in a long wavelength range. Further, it is also shown that light is not absorbed in a range lower than the band gap. Figure 8 illustrates the absorptivity of Ag rods in Ge. As described later, the Ag rods in Ge are formed from Ag-Ge alloy phase separation films according to the sputtering method. The volume ratio of Ag:Ge is 1:9, the Ag rods have 5-nm size and 5-nm interval, and the Ge has an electrical conductivity of $1 \times 10^{-1}$ $(\Omega cm)^{-1}$. Accordingly, the layer has a resistivity of 1 M$\Omega$. The absorptivity is 100%, which is the same as that of Ge, in a short wavelength. On the other hand, however, in a long wavelength range, the layer has absorptivity much larger than that comprising only Ge and further can absorb light in a range lower than the band gap. Figure 9 shows an Ag-Ge layer similar to the layer of Figure 8. In the layer of Figure 9, the volume ratio of Ag:Ge is 1:9, the Ag rods have 5-nm size and 5-nm interval, and the Ge has an electrical conductivity of $1 \times 10^3$ $(\Omega_{cm})^{-1}$. Accordingly, the layer has a resistivity of 100 $\Omega$. The absorptivity is 100%, which is the same as that of Ge, in a short wavelength. On the other hand, however, in a long wavelength range, the layer has absorptivity much larger than that comprising only Ge. Similarly to the layer of Figure 8, the layer of Figure 9 can absorb light in a range lower than the band gap. Since the Ge has a higher electrical conductivity, the layer of Figure 9 absorbs light more than the layer of Figure 8 in a long wavelength range.

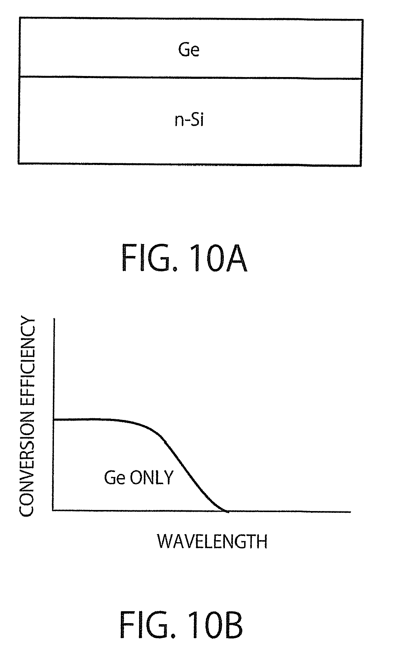

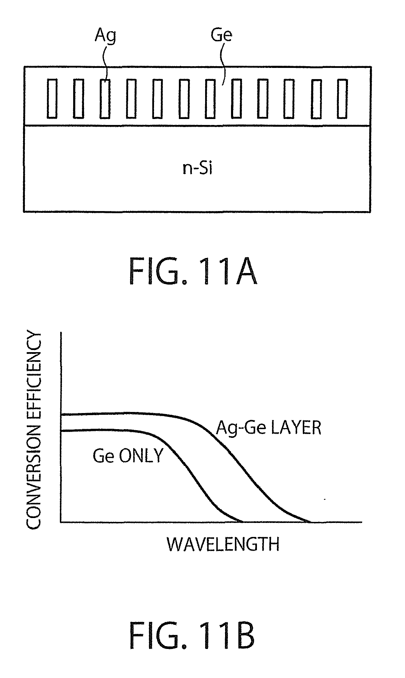

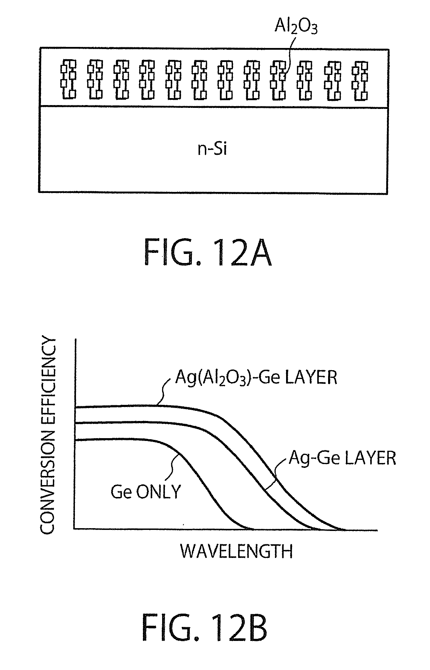

Next, the photoelectric conversion layer is described below. For the purpose of understanding the phenomenon, Ag-(p-type)Ge layers were formed on n-Si substrates to produce photoelectric conversion elements, which were easily obtained. Subsequently, the quantum efficiency of each element was measured. In the following, the thickness of the Ag-Ge layer was 100 nm in common. Figures 10, 11 and 12 provide graphs showing the relations between the wavelength and the quantum efficiency of the n-Si/Ag-Ge layer-type photoelectric conversion elements. The layer of Figure 10 comprised only p-Ge, and had constant quantum efficiency in a short wavelength range. However, since the Ge absorbed light in a small amount, the quantum efficiency decreased in a long wavelength range. The element of Figure 11 had an Ag-(p-type)Ge layer, in which the volume ratio of Ag:Ge was 1:9, the Ag rods had 5-nm size and 5-nm interval, and the Ge had an electrical conductivity of $1 \times 10^3$ $(\Omega cm)^{-1}$. Accordingly, the layer had a resistivity of 100 $\Omega$. The quantum efficiency was similar to that of Ge in a short wavelength. On the other hand, however, in a long wavelength range, the layer had absorptivity much larger than that comprising only Ge and hence the quantum efficiency was remarkably increased. However, in a range lower than the band gap, photovoltaic currents were not generated and hence the quantum efficiency was equal to 0. The element of Figure 12 had an Ag($Al_2O_3$, 50%)-(p-type)Ge layer, in which the volume ratio of Ag:Ge was 1:9, the Ag rods had 5-nm size and 5-nm interval, and the Ge had an electrical conductivity of $5 \times 10^2$ $(\Omega cm)^{-1}$. Accordingly, the layer had a resistivity of 200 $\Omega$. Overall, the quantum efficiency thereof seemed to be similar to but slightly larger than that of the Ag-(p-type)Ge layer in Figure 11. Since the oxide was inserted between Ag and Ge, deactivation at the interface was reduced to improve the quantum efficiency.

<Method of producing a photoelectric conversion element>

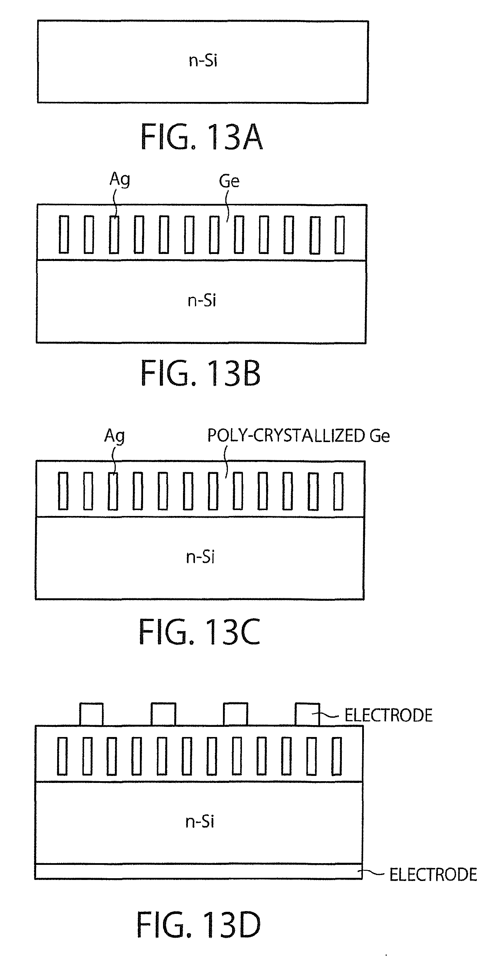

Figure 13 illustrates a method of producing a photoelectric conversion element according to the embodiment. First, as shown in Figure 13(a), an n-type single crystal Si substrate having a doping concentration of $1 \times 10^{16}$ cm$^{-3}$ was prepared. The substrate was then coated with an Ag-Ge layer of 100 nm thickness according to the sputtering method by use of an Ag-Ge target (Figure 13(b)). During formation of the layer, Ag-rods were spontaneously formed in Ge by phase separation. The formed layer was then subjected to annealing so as to poly-crystallize the Ge layer (Figure 13(c)).

Subsequently, the whole back surface of the Si substrate was covered with an electrode of Ti (50 nm)/Ag (200 nm). Finally, an Ag collector electrode was formed on the surface of the Ag-Ge layer, to produce a photoelectric conversion element of n-type Si/Ag-(p-type)Ge (Figure 13(d)).

The above element was produced for the purpose of evaluating the quantum efficiency of the photoelectric conversion layer according to the embodiment, and hence it by no means restricts the structure of the embodiment. The alloy phase separation film can be easily formed by phase separation as long as the metal and the semiconductor are properly combined. Examples of the combination include Ag-Ge, Ag-Si, Au-Ge, and Au-Si. Accordingly, the alloy phase separation film can be readily obtained according to the sputtering method by use of a target of that combination. Further, if an oxide or the like is intended to be inserted between Ag and Ge, as shown in Figure 12, $Al_2O_3$ is homogeneously mixed in an Ag-Ge target or otherwise $Al_2O_3$ is homogeneously mixed in Ag and then an Ag-Ge target is formed, for example. The oxide or the like is not limited to $Al_2O_3$. The method for forming the layer is not limited to the sputtering method, and it is possible to form the layer by co-vapor deposition of Ag and Ge, for example.

<Application of photoelectric conversion layer>

The photoelectric conversion layer of the embodiment can be applied to various optical devices and instruments. Examples of the preferred applications include photoelectric conversion parts and photo-absorption layers of solar cells, photodiodes, image sensors, and other devices.

Because of excellent characteristics and properties of the conversion layer according to the embodiment, a solar cell, photodiode or image sensor comprising the layer of the embodiment has remarkably improved performance, as compared with conventional ones.

Specifically, since the layer of the embodiment is excellent in both sensitivity and efficiency, it is possible to produce a solar cell of very high power as compared with conventional cells. Further, it is also possible to produce a photodiode or image sensor of small size, of light weight and of high precision, as compared with conventional ones. Furthermore, the layer of the embodiment can absorb light even in a long wavelength range and can covert the energy thereof efficiently, and hence those features can be taken advantage of to produce a photodiode of such high sensitivity as cannot be realized by a conventional photoelectric conversion layer.

Accordingly, the solar cell of the embodiment adopts the above photoelectric conversion layer according to the embodiment as a photoelectric converting part.

Further, the photodiode of the embodiment adopts the above photoelectric conversion layer according to the embodiment as a photoelectric converting part.

Furthermore, the image sensor of the embodiment adopts the above photoelectric conversion layer according to the embodiment as a photoelectric converting part.

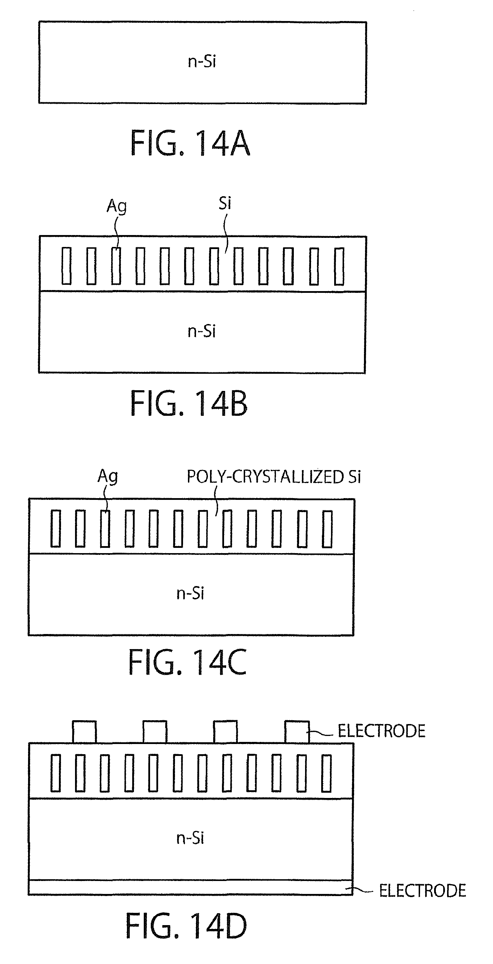

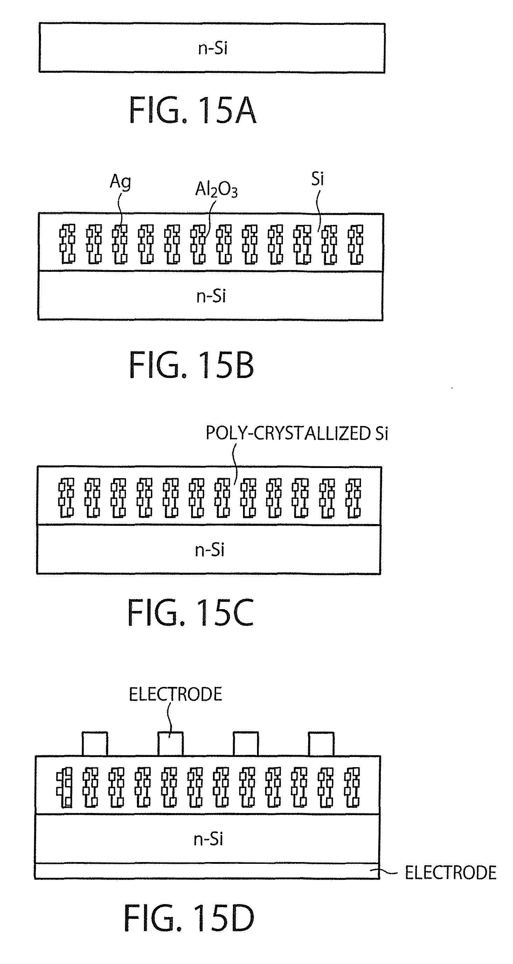

In the solar cell of the embodiment shown in Figure 14(d) or 15(d), the photoelectric conversion layer according to the embodiment is applied as a photoelectric converting part. The solar cell hence comprises a substrate, the conversion layer of the embodiment, and electrodes.

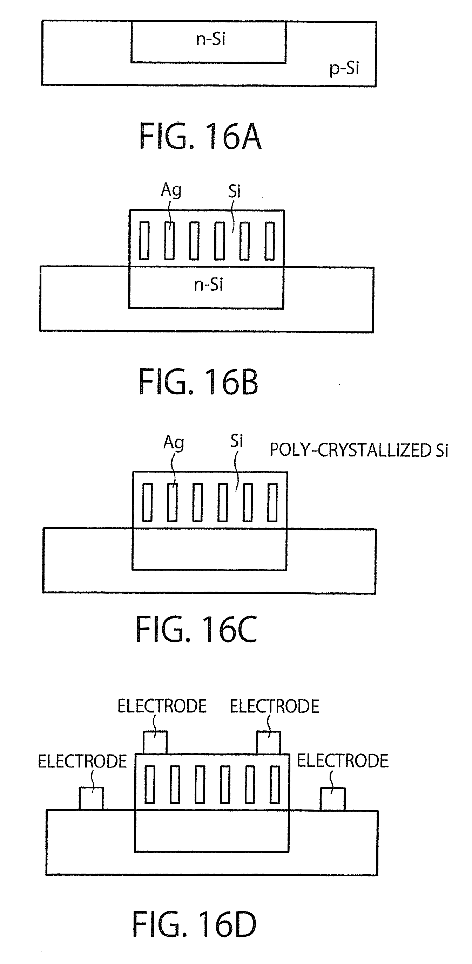

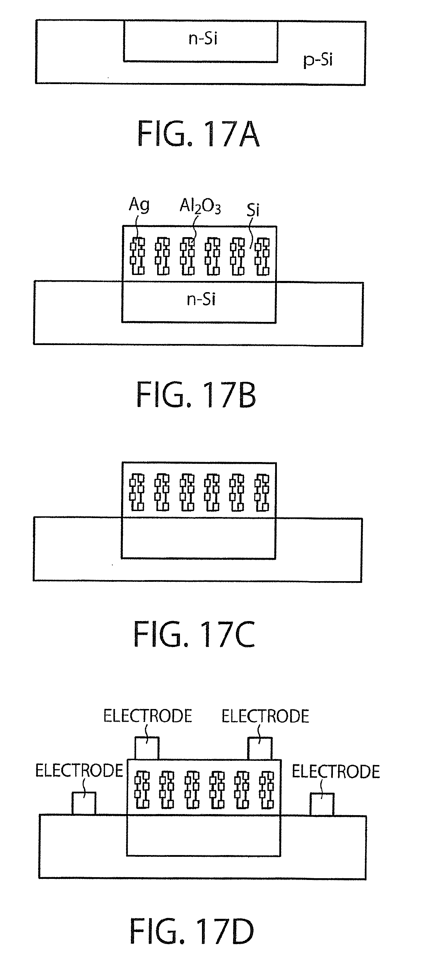

Also in the photodiode of the embodiment shown in Figure 16(d) or 17(d), the photoelectric conversion layer according to the embodiment is applied as a photoelectric converting part. The photodiode hence comprises a substrate, the conversion layer of the embodiment, and electrodes.

Examples

The following describes preferred examples of the photoelectric conversion layer according to the embodiment. Accordingly, needless to say, the photoelectric conversion layer according to the embodiment should by no means be understood and limited only within the scope of the examples described below.

The photoelectric conversion elements according to the embodiments are further explained in detail by use of the examples. Examples of the elements include solar cells, photodiodes (for the visible region), and IR image sensors based on photo-absorption. As for the solar cells, various cells of 9 cm$^2$ were produced and compared in characteristics with a cell having no metal nano-structure.

Examples 1 to 3 were summarized in a table, which indicates that all the cells having metal nano-structures in semiconductors exhibited large conversion efficiencies. Further, it was also revealed that the cells comprising oxides inserted between semiconductors and metals exhibited larger conversion efficiencies.

<Example 1> (single crystal Si, Ag-Si)

A method of producing a photoelectric conversion element in Example 1 is explained by referring to Figure 14.

Figure 14 shows schematic sectional views illustrating the method of producing a photoelectric conversion element of Example 1 according to the embodiment.

First, as shown in Figure 14(a), an n-type single crystal Si substrate having a thickness of 50 μm and a doping concentration of 1 x 10$^{16}$ cm$^{-3}$ was prepared. The substrate was then coated with an Ag-Si layer of 100 nm thickness according to the sputtering method under the conditions of pressure: 0.2 Pa and 300 W by use of an Ag(20 at.%)-Si(80 at.%) target (Figure 14(b)). During formation of the layer, Ag-rods were spontaneously formed in Si by phase separation. The rods were 4 nm in size and 5 nm in interval. The formed layer was then subjected to annealing under nitrogen atmosphere at 400°C for 30 minutes so as to poly-crystallize the Si layer (Figure 14(c)). The Si in the layer was of p-type and contained in a concentration of 1 x 10$^{18}$ cm$^{-3}$. Subsequently, the whole back surface of the Si substrate was covered with an electrode of Ti (50 nm)/Ag (200 nm) according to the sputtering method. Finally, an Ag interdigitated electrode was formed by vapor deposition on the surface of the Ag-Si layer, to produce a photoelectric conversion element of n-type Si/Ag-(p-type)Si (Figure 14(d)).

(Characteristics of solar cell)

The above produced photoelectric conversion element was exposed to pseudo-sunlight of AM 1.5, to evaluate photoelectric conversion efficiency at room temperature. As a result, the conversion element of n-type Si/Ag-(p-type)Si showed a photoelectric conversion efficiency of 10%.

On the other hand, an n-type Si/(p-type)Si conversion element having no Ag nano-structure showed a photoelectric conversion efficiency of 8.0%.

Further, spectral sensitivity characteristics were also evaluated. As a result, the n-type Si/(p-type)Si element having no Ag nano-structure showed poor quantum efficiency in a wavelength range longer than 800 nm. That is because the thickness of Si was too thin to absorb light. In contrast, the reason why the n-type Si/Ag-(p-type)Si element showed large quantum efficiency is presumed to be because the Ag-Si layer absorbed light of 800 nm or more in a large amount. The above results indicate that the photoelectric conversion efficiency was increased because of increase of photo absorption.

<Example 2> (single crystal Si, Ag (Al$_2$O$_3$, 50%)-Si)

A method of producing a photoelectric conversion element in Example 2 is explained by referring to Figure 15.

Figure 15 shows schematic sectional views illustrating the method of producing a photoelectric conversion element of Example 2 according to the embodiment.

First, as shown in Figure 15(a), an n-type single crystal Si substrate having a thickness of 50 μm and a doping concentration of 1 x 10$^{16}$ cm$^{-3}$ was prepared. The substrate was then coated with an Ag-Si layer of 100 nm thickness according to the sputtering method under the conditions of pressure: 0.2 Pa and 300 W by use of an Ag (Al$_2$O$_3$, 50%) 20 at.%-Si 80 at.% target (Figure 15(b)). During formation of the layer, Ag-rods were spontaneously formed in Si by phase separation. The rods were 4 nm in size and 4 nm in interval. The formed layer was then subjected to annealing under nitrogen atmosphere at 400°C for 30 minutes so as to poly-crystallize the Si layer (Figure 15(c)). The Si in the layer was of p-type and contained in a concentration of 1 x 10$^{18}$ cm$^{-3}$. Subsequently, the whole back surface of the Si substrate was covered with an electrode of Ti (50 nm)/Ag (200 nm) according to the sputtering method. Finally, an Ag interdigitated electrode was formed by vapor deposition on the surface of the Ag-Si layer, to produce a photoelectric conversion element of n-type Si/Ag-(p-type)Si (Figure 15(d)).

(Characteristics of solar cell)

The above produced photoelectric conversion element was exposed to pseudo-sunlight of AM 1.5, to evaluate photoelectric conversion efficiency at room temperature. As a result, the conversion element of n-type Si/Ag (Al$_2$O$_3$, 50%)-(p-type)Si showed a photoelectric conversion efficiency of 14%.

On the other hand, an n-type Si/p-type Si conversion element having no Ag nano-structure showed a photo-lectric conversion efficiency of 5.0%. The conversion efficiency of the produced element was also larger than that of the element in Example 1.

Further, spectral sensitivity characteristics were also evaluated. As a result, overall, the produced element showed higher quantum efficiency than the n-type Si/Ag-(p-type)Si element. That seemed to mean that the produced element had higher conversion efficiency. The results thus indicate that Al$_2$O$_3$ inserted between Ag and Si reduced deactivation at the interface and thereby increased the quantum efficiency to improve the conversion efficiency.

<Example 3> to <Example 16>

Solar cells shown in Table 1 were produced and then characteristics thereof were individually evaluated. The results were as set forth in Table 1.

<Example 17>

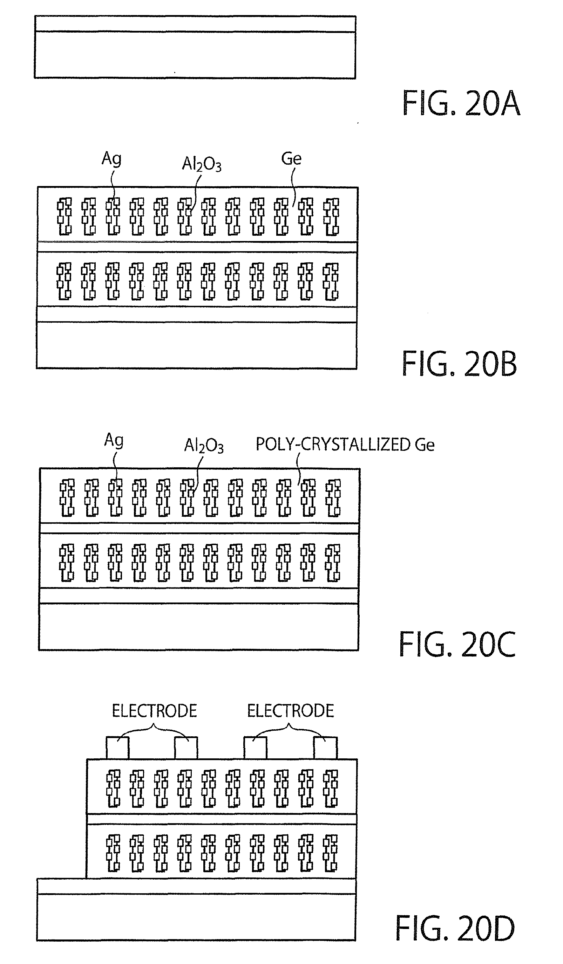

A method of producing a photoelectric conversion element in Example 17 is explained by referring to Figure 20.

Figure 20 shows schematic sectional views illustrating the method of producing a solar cell according to the embodiment.

First, as shown in Figure 20(a), a glass substrate of 500 $\mu$m thickness was prepared and coated with an Ag/Ti electrode according to the sputtering method.

Subsequently, an Ag-Ge layer of 50 nm thickness was formed thereon according to the sputtering method under the conditions of pressure: 0.2 Pa and 300 W by use of an Ag ($Al_2O_3$, 50%) 30 at.%-Ge (containing 1% of Sb) 70 at.% target (Figure 20(b)). The additive Sb incorporated into Ge was aimed to serve as an n-type dopant.

Successively, a Ge layer of 10 nm thickness was formed thereon according to the sputtering method under the conditions of pressure: 0.2 Pa and 300 W by use of a Ge target (Figure 20(b)).

Further successively, another Ag-Ge layer of 50 nm thickness was formed on the Ge layer according to the sputtering method under the conditions of pressure: 0.2 Pa and 300 W by use of an Ag ($Al_2O_3$, 50%) 30 at.%-Ge (containing 1% of Al) 70 at.% target (Figure 20(b)). The additive Al incorporated into Ge was aimed to serve as a p-type dopant. During formation of the layers, Ag-rods were spontaneously formed in Ge by phase separation. The rods were 5 nm in size and 5 nm in interval.

The formed layers were then subjected to annealing under nitrogen atmosphere at 300°C for 30 minutes so as to poly-crystallize the Ge layers (Figure 20(c)). The Ge layers had an n-type concentration of 1 x $10^{17}$ $cm^{-3}$ and a p-type concentration of 1 x $10^{18}$ $cm^{-3}$. The Ge layer of 10 nm thickness sandwiched between the p-type Ge layer and the n-type Ge layer functioned as a buffer layer to separate the Ag rods in one layer from those in the other layer.

Thereafter, the Ge layers were subjected to laser-patterning to bare the underlying Ag/Ti electrode.

Finally, an Ag interdigitated electrode was formed by vapor deposition on the surface of the Ag-Ge layer, to produce a photoelectric conversion element (Figure 20(d)).

(Characteristics of solar cell)

The above produced photoelectric conversion element was exposed to pseudo-sunlight of AM 1.5, to evaluate photoelectric conversion efficiency at room temperature. As a result, the conversion element showed a photoelectric conversion efficiency of 4.2%.

On the other hand, a conversion element having no Ag nano-structure showed a photoelectric conversion efficiency of 2.0%.

That is thought to be because of the following reason. The thin conversion element having no Ag nano-structure absorbed light in a small amount and hence showed poor quantum efficiency in the whole wavelength range, and therefore the Ag nano-structures remarkably enhanced photo-absorption to increase the quantum efficiency. The above results indicate that the photoelectric conversion efficiency was increased because of increase of photo absorption.

<Example 18>

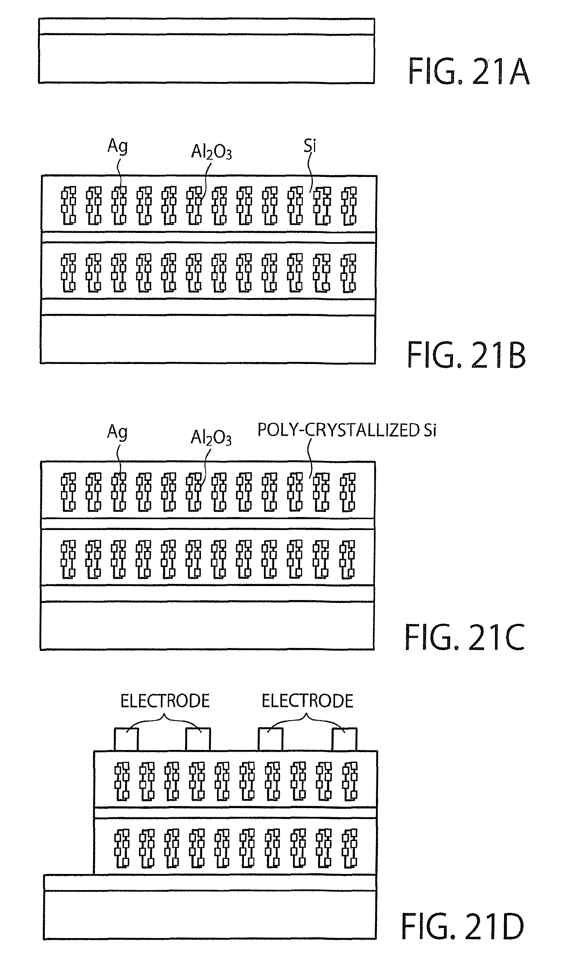

A method of producing a photoelectric conversion element in Example 18 is explained by referring to Figure 21.

Figure 21 shows schematic sectional views illustrating the method of producing a solar cell according to the embodiment.

First, as shown in Figure 21(a), a glass substrate of 500 $\mu$m thickness was prepared and coated with an Ag/Ti electrode according to the sputtering method.

Subsequently, an Ag-Si layer of 50 nm thickness was formed thereon according to the sputtering method under the conditions of pressure: 0.2 Pa and 300 W by use of an Ag ($Al_2O_3$, 50%) 20 at.%-Si (containing 1% of Sb) 80 at.% target (Figure 21(b)). The additive Sb incorporated into Si was aimed to serve as an n-type dopant.

Successively, a Si layer of 10 nm thickness was formed thereon according to the sputtering method under the conditions of pressure: 0.2 Pa and 300 W by use of a Si target (Figure 21(b)).

Further successively, another Ag-Si layer of 100 nm thickness was formed on the Si layer according to the sputtering method under the conditions of pressure: 0.2 Pa and 300 W by use of an Ag ($Al_2O_3$, 50%) 20 at.%-Si (containing 1% of Al) 80 at.% target (Figure 21(b)). The additive Al incorporated into Si was aimed to serve as a p-type dopant. During formation of the layers, Ag-rods were spontaneously formed in Si by phase separation. The rods were 4 nm in size and 5 nm in interval. The formed layers were then subjected to annealing under nitrogen atmosphere at 400°C for 30 minutes so as to poly-crystallize the Si layers (Figure 21(c)). The Si layers had an n-type concentration of 1 x $10^{17}$ $cm^{-3}$ and a p-type concentration of 1 x $10^{18}$ $cm^{-3}$. The Si layer of 10 nm thickness sandwiched between the p-type Si layer and the n-type Si layer functioned as a buffer layer to separate the Ag rods in one layer from those in the other layer.

Thereafter, the Si layers were subjected to laser-patterning to bare the underlying Ag/Ti electrode.

Finally, an Ag interdigitated electrode was formed by vapor deposition on the surface of the Ag-Si layer, to produce a photoelectric conversion element (Figure 21(d)).

(Characteristics of solar cell)

The above produced photoelectric conversion element was exposed to pseudo-sunlight of AM 1.5, to evaluate photoelectric conversion efficiency at room temperature. As a result, the conversion element showed a photoelectric conversion efficiency of 6.2%.

On the other hand, a conversion element having no Ag nano-structure showed a photoelectric conversion efficiency of 1.0%.

That is thought to be because of the following reason. The thin conversion element having no Ag nano-structure absorbed light in a small amount and hence showed poor quantum efficiency in the whole wavelength range, and therefore the Ag nano-structures remarkably enhanced photo-absorption to increase the quantum efficiency. The above results indicate that the photoelectric conversion efficiency was increased because of increase of photo-absorption.

<Example 19> to <Example 24>

Solar cells shown in Table 1 were produced and then characteristics thereof were individually evaluated. The results were as set forth in Table 1.

Table 1

| | Cell constitution | Nano-structure size | Conversion efficiency | Conversion efficiency (ref.) |
|---|---|---|---|---|
| Ex. 1 | n-Si(50$\mu$m)/Ag-Si(100nm) | 4 nm, 5 nm | 10.50% | 8.00% |
| Ex. 2 | n-Si(50$\mu$m)/Ag(Al$_2$O$_3$, 50%)-Si(100nm) | 4 nm, 5 nm | 14.30% | 8.00% |
| Ex. 3 | n-Si(100$\mu$m)/Ag-Ge(50nm) | 5 nm, 5 nm | 5.20% | 3.00% |
| Ex. 4 | n-Si(100$\mu$m)/Ag(Al$_2$O$_3$, 30%)-Ge(50nm) | 5 nm, 5 nm | 6.10% | 3.00% |
| Ex. 5 | n-Si(50$\mu$m)/Au-Si(100nm) | 3 nm, 6 nm | 9.50% | 8.00% |
| Ex. 6 | n-Si(50$\mu$m)/Au(Al$_2$O$_3$, 70%)-Si(100nm) | 4 nm, 7 nm | 12.80% | 8.00% |
| Ex. 7 | n-Si (100$\mu$m)/Au-Ge(50nm) | 3 nm, 8 nm | 4.70% | 3.00% |
| Ex. 8 | n-Si(50$\mu$m)/Ag-Si(500nm) | 4 nm, 5 nm | 9.50% | 7.50% |
| Ex. 9 | n-Si(50$\mu$m)/Ag-Si(1000m) | 4 nm, 5 nm | 7.20% | 5.00% |
| Ex. 10 | n-Si(50$\mu$m)/Ag(TiOl$_2$, 20%)-Si(100nm) | 4 nm, 6 nm | 12.60% | 8.00% |
| Ex. 11 | n-Si(100$\mu$m)/Ag(PdO, 60%)-Ge(50nm) | 2 nm, 7 nm | 5.70% | 3.00% |
| Ex. 12 | n-Si(50$\mu$m)/Al-Si(100nm) | 7 nm, 8 nm | 9.00% | 8.00% |
| Ex. 13 | n-Si(100$\mu$m)/Al(SiO$_2$, 30%)-Ge(50nm) | 10 nm, 5 nm | 3.50% | 3.00% |
| Ex. 14 | n-Si(50$\mu$m)/PdSi-Si(100nm) | 2nm,3nm | 8.50% | 8.00% |

(continued)

| | Cell constitution | Nano-structure size | Conversion efficiency | Conversion efficiency (ref.) |
|---|---|---|---|---|
| Ex. 15 | n-Si(100$\mu$m)/Cu$_3$Ge(SiN, 10%)-Ge(50nm) | 5 nm, 5nm | 3.60% | 3.00% |
| Ex. 16 | n-Si(50$\mu$m)/Ag-SiGe(100nm) | 4 nm, 5 nm | 8.10% | 5.50% |
| Ex. 17 | grass substrate/etectrode/Ag(Al$_2$O$_3$, 50%)-n-Ge(50nm) /Ge(10nm)/Ag(Al$_2$O$_3$, 50%)-p-Ge(50nm) | 5 nm, 5nm | 4.20% | 2.00% |
| Ex. 18 | grass substrate/electrode/Ag(Al$_2$O$_3$, 50%)-n-Si(100nm) /Si(10nm)/Ag(Al$_2$O$_3$, 50%)-p-Si(100nm) | 4 nm, 5 nm | 6.20% | 1.00% |
| Ex.19 | n-GaAs(50 $\mu$m)/Ag-GaAs(50nm) | 3 nm, 5 nm | 7.50% | 6.00% |
| Ex. 20 | n-GaAs(50 $\mu$m)/Ag(AlN, 10%)-GaAs(50nm) | 3 nm, 5 nm | 7.80% | 6.00% |
| Ex. 21 | n-GaP(50 $\mu$m)/Au-GaP(50nm) | 5 nm, 6 nm | 5.50% | 4.00% |
| Ex. 22 | n-GaP(50 $\mu$m)/Au(SiON, 20%)-GaP(50nm) | 5 nm, 6 nm | 5.90% | 4.00% |
| Ex. 23 | n-GaN(50 $\mu$m)/Ag-GaN(50nm) | 3 nm, 5 nm | 3.50% | 2.00% |
| Ex. 24 | n-GaN(50 $\mu$m)/Ag(ZnO, 30%)-GaN(50nm) | 3 nm, 5 nm | 4.00% | 2.00% |

<Example 25> (Ag-Si) (example of photodiode)

A method of producing a photoelectric conversion element in Example 25 is explained by referring to Figure 16.

Figure 16 shows schematic sectional views illustrating the method of producing a photodiode according to the embodiment.

First, as shown in Figure 16(a), a p-type single crystal Si substrate halving a thickness of 300 $\mu$m and a doping concentration of 1 x 10$^{16}$ cm$^{-3}$ was prepared.

After subjected to ion implantation with P ions, the substrate was subjected to activation annealing to form an n+ layer of 1 x 10$^{16}$-cm$^{-3}$ concentration within 0.9 $\mu$m depth from the Si surface.

Subsequently, an Ag-Si layer of 100-nm thickness was formed thereon according to the sputtering method under the conditions of pressure: 0.2 Pa and 300 W by use of an Ag 20 at.%-Si 80 at.% target (Figure 16(b)). During formation of the layer, Ag-rods were spontaneously formed in Si by phase separation. The rods were 4 nm in size and 4 nm in interval. The formed layer was then subjected to annealing under nitrogen atmosphere at 400°C for 30 minutes so as to poly-crystallize the Si layer (Figure 16(c)). The Si in the layer was of p-type and contained in a concentration of 1 x 10$^{18}$ cm$^{-3}$. Thereafter, a Ti/Ag electrode and an Ag collector electrode were formed on the n-Si layer and the Ag-Si layer, respectively, to produce a photodiode of n-Si/Ag-(p-type)Si (Figure 16(d)).

(Characteristics of photodiode)

The above produced photodiode was exposed to light of R (650 nm), G (550 nm) or B (450 nm), to evaluate photovoltaic currents of the diode at room temperature in terms of current ratio to those of the reference. As the reference, an n-Si/p-Si photodiode was produced. First, a p-type single crystal Si substrate having a thickness of 300 $\mu$m and a doping concentration of 1 x 10$^{16}$ cm$^{-3}$ was prepared. After subjected to ion implantation with P ions, the substrate was subjected to activation annealing to form an n layer of 1 x 10$^{16}$-cm$^{-3}$ concentration within 1 $\mu$m depth from the Si surface. Subsequently, the substrate was subjected to ion implantation with B ions, and then subjected to activation annealing to form a p layer of 1 x 10$^{18}$-cm$^{-3}$ concentration within 0.2 $\mu$m depth from the Si surface. Finally, electrodes were formed in the same manner as the above, to produce the photodiode.

With respect to any light of R, G and B, the photodiode having the Ag nano-structures showed a larger current ratio. Further, the rate of increase in red light was larger than that in blue light. That is presumed to be because the diode of Si only had such low quantum efficiency in itself in a long wavelength range as to raise the rate of increase in red light. The above results indicate that the photovoltaic currents were increased because of increase of photo-absorption.

<Example 26> (Ag(Al$_2$O$_3$, 50%) -Si) (example of photodiode)

A method of producing a photoelectric conversion element in Example 26 is explained by referring to Figure 17. Figure 17 shows schematic sectional views illustrating the method of producing a photodiode according to the embodiment.

First, as shown in Figure 17(a), a p-type single crystal Si substrate having a thickness of 300 $\mu$m and a doping concentration of 1 x 10$^{16}$ cm$^{-3}$ was prepared.

After subjected to ion implantation with P ions, the substrate was subjected to activation annealing to form an n layer of 1 x 10$^{16}$-cm$^{-3}$ concentration within 0.9 $\mu$m depth from the Si surface.

Subsequently, an Ag-Si layer of 100-nm thickness was formed thereon according to the sputtering method under the conditions of pressure: 0.2 Pa and 300 W by use of an Ag(Al$_2$O$_3$, 50%) 20 at.%-Si 80 at.% target (Figure 17(b)). During formation of the layer, Ag-rods were spontaneously formed in Si by phase separation. The rods were 4 nm in size and 4 nm in interval. The formed layer was then subjected to annealing under nitrogen atmosphere at 400°C for 30 minutes so as to poly-crystallize the Si layer (Figure 17(c)). The Si in the layer was of p-type and contained in a concentration of 1 x 10$^{18}$ cm$^{-3}$. Thereafter, a Ti/Ag electrode and an Ag collector electrode were formed on the n-Si layer and the Ag-Si layer, respectively, to produce a photodiode of n-Si/Ag-(p-type)Si (Figure 17(d)).

(Characteristics of photodiode)

The above produced photodiode was exposed to light of R (650 nm), G (550 nm) or B (450 nm), to evaluate photovoltaic currents of the diode at room temperature in terms of current ratio to those of the reference. As the reference, an n-Si/p-Si photodiode was produced. First, a p-type single crystal Si substrate having a thickness of 300 $\mu$m and a doping concentration of 1 x 10$^{16}$ cm$^{-3}$ was prepared. After subjected to ion implantation with P ions, the substrate was subjected to activation annealing to form an n layer of 1 x 10$^{16}$-cm$^{-3}$ concentration within 1 $\mu$m depth from the Si surface. Subsequently, the substrate was subjected to ion implantation with B ions, and then subjected to activation annealing to form a p layer of 1 x 10$^{18}$-cm$^{-3}$ concentration within 0.2 $\mu$m depth from the Si surface. Finally, electrodes were formed in the same manner as the above, to produce the photodiode.

With respect to any light of R, G and B, the photodiode having the Ag nano-structures showed a larger current ratio. Further, the rate of increase in red light was larger than that in blue light. That is presumed to be because the diode of Si only had such low quantum efficiency in itself in a long wavelength range as to raise the rate of increase in red light. The above results indicate that the photovoltaic currents were increased because of increase of photo-absorption.

In addition, since Al$_2$O$_3$ was inserted between Ag and Si, the photovoltaic currents were increased as compared with the diode of Ag-Si.

<Example 27> and <Example 28>

Photodiodes shown in Table 2 were produced and then characteristics thereof were individually evaluated. The results were as set forth in Table 2.

Table 2

| | Constitution of photoelectric conversion layer | Size of metal nano-structure | Ratio in R | Ratio in G | Ratio in B |
|---|---|---|---|---|---|
| Ex. 25 | Ag-Si(100nm) | 4 nm, 5 nm | 1.3 | 1.1 | 1 |
| Ex. 26 | Ag(Al$_2$O$_3$, 50%)-Si(100nm) | 4 nm, 4 nm | 1.5 | 1.15 | 1.05 |
| Ex. 27 | Ag-Ge(100nm) | 5 nm, 5 nm | 1.2 | 1.05 | 0.9 |
| Ex. 28 | Ag(Al$_2$O$_3$, 30%)-Ge(100nm) | 5 nm, 5 nm | 1.3 | 1.1 | 1 |
| REF: p-Si substrate containing n-Si layer 1 $\mu$m/p-Si layer 0.2 $\mu$m  p-Si substrate containing n-Si layer 0.9 $\mu$m /0.1 $\mu$m | | | | | |

<Example 29> (example of IR sensor)

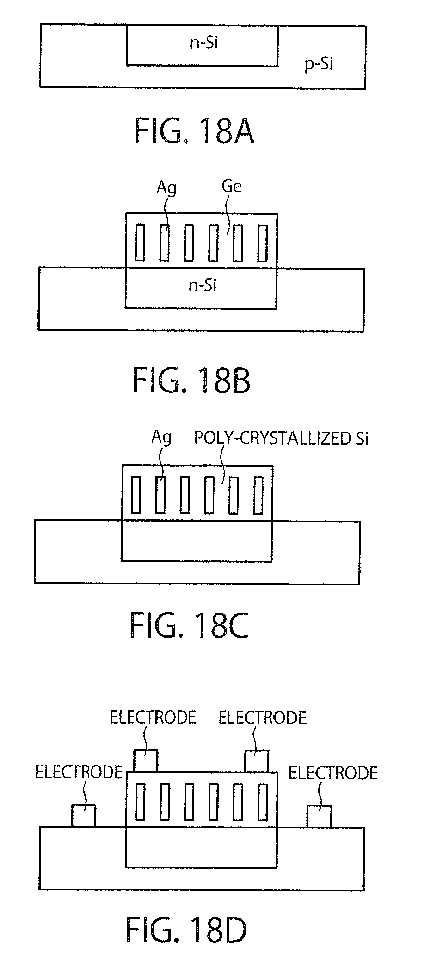

A method of producing a photoelectric conversion element in Example 29 is explained by referring to Figure 18. Figure 18 shows schematic sectional views illustrating the method of producing a photodiode according to the embodiment.

First, as shown in Figure 18(a), a p-type single crystal Si substrate having a thickness of 300 $\mu$m and a doping concentration of 1 x $10^{16}$ cm$^{-3}$ was prepared.

After subjected to ion implantation with P ions, the substrate was subjected to activation annealing to form an n layer of 1 x $10^{16}$-cm$^{-3}$ concentration within 1 $\mu$m depth from the Si surface.

Subsequently, an Ag-Ge layer of 100-nm thickness was formed thereon according to the sputtering method under the conditions of pressure: 0.2 Pa and 300 W by use of an Ag 30 at.%-Ge 70 at.% target (Figure 18(b)). During formation of the layer, Ag-rods were spontaneously formed in Ge by phase separation. The rods were 5 nm in size and 5 nm in interval. The formed layer was then subjected to annealing under nitrogen atmosphere at 300°C for 30 minutes so as to poly-crystallize the Ge layer (Figure 18(c)). The Ge in the layer was of p-type and contained in a concentration of 1 x $10^{18}$ cm$^{-3}$. Thereafter, a Ti/Ag electrode and an Ag collector electrode were formed on the n-Si layer and the Ag-Ge layer, respectively, to produce a photodiode of n-Si/Ag-(p-type)Ge (Figure 18(d)).

(Characteristics of photodiode)

The above produced photodiode was exposed to IR light of 1.3 $\mu$m or 1.55 $\mu$m, to evaluate photovoltaic currents of the diode at room temperature in terms of current ratio to those of the reference. As the reference, an n-Si/p-Ge photodiode was produced. First, a p-type single crystal Si substrate having a thickness of 300 $\mu$m and a doping concentration of 1 x $10^{16}$ cm$^{-3}$ was prepared. After subjected to ion implantation with P ions, the substrate was subjected to activation annealing to form an n layer of 1 x $10^{16}$-cm$^{-3}$ concentration within 1 $\mu$m depth from the Si surface. Subsequently, a Ge layer of 100-nm thickness was formed on the Si substrate according to the sputtering method under the conditions of pressure: 0.2 Pa and 300 W by use of a Ge target. The formed layer was then subjected to annealing under nitrogen atmosphere at 450°C for 30 minutes so as to poly-crystallize the Ge layer. The Ge in the layer was of p-type and contained in a concentration of 1 x $10^{18}$ cm$^{-3}$. Finally, electrodes were formed in the same manner as the above, to produce the photodiode.

With respect to either IR light of 1.3 $\mu$m and 1.55 $\mu$m, the photodiode having the Ag nano-structures showed a larger current ratio. Further, the rate of increase at 1.55 $\mu$m was larger than that at 1.3 $\mu$m. That is presumed to be because the diode of Ge only had such low quantum efficiency in itself in a long wavelength range as to raise the rate of increase at 1.55 $\mu$m. The above results indicate that the photovoltaic currents were increased because of increase of photo-absorption.

<Example 30> (Ag(Al$_2$O$_3$, 50%) -Ge)

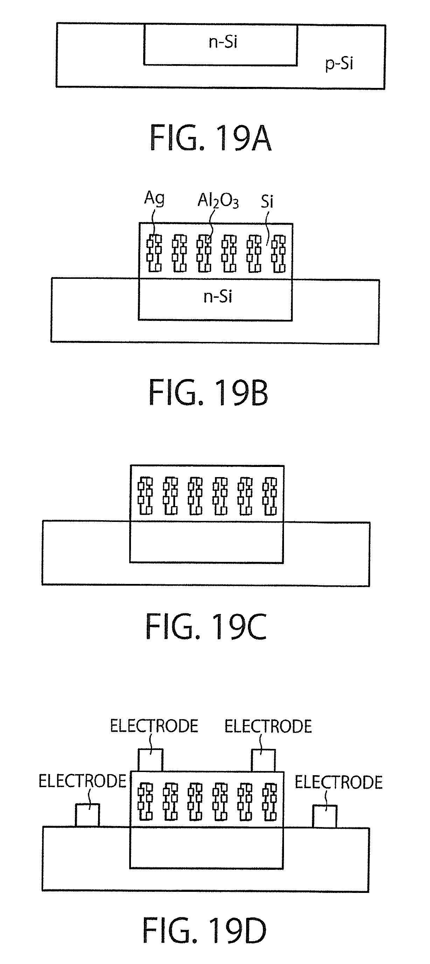

A method of producing a photoelectric conversion element in Example 30 is explained by referring to Figure 19. Figure 19 shows schematic sectional views illustrating the method of producing a photodiode according to the embodiment.

First, as shown in Figure 19(a), a p-type single crystal Si substrate having a thickness of 300 $\mu$m and a doping concentration of 1 x $10^{16}$ cm$^{-3}$ was prepared.

After subjected to ion implantation with P ions, the substrate was subjected to activation annealing to form an n layer of 1 x $10^{16}$-cm$^{-3}$ concentration within 1 $\mu$m depth from the Si surface.

Subsequently, an Ag-Ge layer of 100-nm thickness was formed thereon according to the sputtering method under the conditions of pressure: 0.2 Pa and 300 W by use of an Ag(Al$_2$O$_3$, 50%) 30 at.%-Ge 70 at.% target (Figure 19(b)). During formation of the layer, Ag-rods were spontaneously formed in Ge by phase separation. The rods were 4 nm in size and 5 nm in interval. The formed layer was then subjected to annealing under nitrogen atmosphere at 300°C for 30 minutes so as to poly-crystallize the Ge layer (Figure 19(c)). The Ge in the layer was of p-type and contained in a concentration of 1 x $10^{18}$ cm$^{-3}$. Thereafter, a Ti/Ag electrode and an Ag collector electrode were formed on the n-Si layer and the Ag-Ge layer, respectively, to produce a photodiode of n-Si/Ag-(p-type)Si (Figure 19(d)).

(Characteristics of photodiode)

The above produced photodiode was exposed to IR light of 1.3 $\mu$m or 1.55 $\mu$m, to evaluate photovoltaic currents of the diode at room temperature in terms of current ratio to those of the reference. As the reference, an n-Si/p-Ge photodiode was produced. First, a p-type single crystal Si substrate having a thickness of 300 $\mu$m and a doping concentration of 1 x $10^{16}$ cm$^{-3}$ was prepared. After subjected to ion implantation with P ions, the substrate was subjected to activation annealing to form an n layer of $1 \times 10^{16}$-$cm^{-3}$ concentration within 1 $\mu$m depth from the Si surface. Subsequently, a Ge layer of 100-nm thickness was formed thereon according to the sputtering method under the conditions of pressure: 0.2 Pa and 300 W by use of a Ge target. The formed layer was then subjected to annealing under nitrogen atmosphere at 450°C for 30 minutes so as to poly-crystallize the Ge layer. The Ge in the layer was of p-type and contained in a concentration of $1 \times 10^{18}$ $cm^{-3}$. Finally, electrodes were formed in the same manner as the above, to produce the photodiode.

With respect to either IR light of 1.3 $\mu$m and 1.55 $\mu$m, the photodiode having the Ag nano-structures showed a larger current ratio. Further, the rate of increase at 1.55 $\mu$m was larger than that at 1.3 $\mu$m. That is presumed to be because the diode of Ge only had such low quantum efficiency in itself in a long wavelength range as to raise the rate of increase at 1.55 $\mu$m. The above results indicate that the photovoltaic currents were increased because of increase of photo-absorption.

In addition, since $Al_2O_3$ was inserted between Ag and Ge, the photovoltaic currents were increased as compared with the diode of Ag-Ge.

<Example 31> and <Example 32>

Photodiodes shown in Table 3 were produced and then characteristics thereof were individually evaluated. The results were as set forth in Table 3.

Table 3

|  | Constitution of photoelectric conversion layer | Size of metal nano-structure | 1.3$\mu$m | 1.55$\mu$m |
|---|---|---|---|---|
| Ex. 29 | Ag-Si(100nm) | 5 nm, 5 nm | 3.3 | 3.8 |
| Ex. 30 | Ag($Al_2O_3$, 50%)-Si(100nm) | 4 nm, 5 nm | 3.6 | 4.2 |
| Ex. 31 | Ag-Ge(100nm) | 7 nm, 7nm | 2.2 | 2.4 |
| Ex. 32 | Ag($Al_2O_3$, 30%)-Ge(100nm) | 6 nm, 6nm | 2.6 | 2.8 |
| REF: p-Si substrate containing n-Si layer 1 $\mu$m/p-Ge layer 100 nm | | | | |

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the invention.

**Claims**

1. A photoelectric conversion layer containing a semiconductor and plural metal-containing minute structures dispersed in said semiconductor, wherein
said metal-containing minute structures are selected from (A) or (B);

(A) metal-containing minute structures comprising metal material;
(B) metat-contaiting minute structures comprising metal material ($\alpha$) and material ($\beta$) selected from the group consisting of oxide, nitride and oxynitride of substances different from either of said metal material ($\alpha$) and said semiconductor, provided that said material ($\beta$) is on the surface of said metal material ($\alpha$); and

each of said metal-containing minute structures has an equivalent circle diameter of 1 nm to 10 nm inclusive on the basis of the projected area when observed from the direction in which said metal-containing minute structures have the smallest projected area in total, and the closest distance between adjacent two of said metal-containing minute structures is 3 nm to 50 nm inclusive.

2. The layer according to claim 1, wherein said metal-containing minute structures are in the shape of dots, rods or a mixture thereof.

3. The layer according to claim 1 or 2, wherein said plural metal-containing minute structures are in the shape of rods and are oriented parallel to the basis of the projected area when observed from the direction in which said metal-containing minute structures have the smallest projected area in total.

4. The layer according to one of claims 1 to 3, wherein the total projected area of said metal minute structures is in the range of 5 to 50% inclusive based on the projected area of the whole photoelectric conversion layer.

5. The layer according to one of claims 1 to 4, wherein said metal-containing minute structures are said metal-containing minute structures (B) in which said material ($\beta$) is contained in an amount of 10 to 90 wt% inclusive based on the total weight of said metal material ($\alpha$) and said material ($\beta$).

6. The layer according to one of claims 1 to 5, wherein said semiconductor is a poly-crystal type semiconductor or a single crystal type semiconductor.

7. The layer according to one of claims 1 to 6, wherein said semiconductor has an electrical conductivity of $1 \times 10^{-3}$ to $1 \times 10^4$ $(\Omega cm)^{-1}$.

8. The layer according to one of claims 1 to 7, wherein said semiconductor is selected from the group consisting of Si, Ge, SiGe, GaAs, GaP and GaN.

9. The layer according to one of claims 1 to 8, wherein said metal material ($\alpha$) is selected from the group consisting of Ag, Au, Al, Cu, PdSi, NiSi, PtSi, $FeSi_2$, $Cu_3Si$, PdGe, NiGe, PtGe and $Cu_3Ge$.

10. The layer according to one of claims 1 to 9, wherein said material ($\beta$) is selected from the group consisting of AlOx (where X is 0.5 to 4), $SiO_2$, ZnO, MgO, ZrO, $TiO_2$, ITO, $Ta_2O_5$, AIN, AlON, SiN, SiON, PdO and CdO.

11. The layer according to one of claims 1 to 10, wherein said semiconductor is in the form of a layer having a thickness of 10 to 1000 nm inclusive.

12. A solar cell wherein the photoelectric conversion layer according to one of claims 1 to 11 is applied as a photoelectric converting part.

13. A photodiode wherein the photoelectric conversion layer according to one of claims 1 to 11 is applied as a photoelectric converting part.

14. An image sensor wherein the photoelectric conversion layer according to one of claims 1 to 11 is applied as a photoelectric converting part.

4

1

2   3

## FIG. 1

SEMICONDUCTOR

## FIG. 2A

ABSORPTIVITY

SEMICONDUCTOR

WAVELENGTH

## FIG. 2B

METAL NANO-STRUCTURE

SEMICONDUCTOR

FIG. 3A

FIG. 3B

METAL NANO-STRUCTURE

SEMICONDUCTOR

# FIG. 4A

ABSORPTIVITY

METAL NANO-STRUCTURE

SEMICONDUCTOR

WAVELENGTH

# FIG. 4B

SHORT WAVELENGTH

ABSORB

Ge    Ag

FIG. 5A

LONG WAVELENGTH

ABSORB

Ag

Ge

FIG. 5B

METAL NANO-STRUCTURE

METAL    SEMICONDUCTOR

FIG. 6A

METAL NANO-STRUCTURE WITH OXIDE

METAL   SEMICONDUCTOR   OXIDE

FIG. 6B

Ge

## FIG. 7A

ABSORPTIVITY

Ge ONLY

WAVELENGTH

## FIG. 7B

METAL NANO-STRUCTURE

Ag    Ge

# FIG. 8A

ABSORPTIVITY

Ag-Ge LAYER

Ge ONLY

WAVELENGTH

# FIG. 8B

METAL NANO-STRUCTURE

Ag

Ge (HIGH ELECTRICAL CONDUCTIVITY)

FIG. 9A

Ag-Ge LAYER
(HIGH ELECTRICAL
CONDUCTIVITY)

ABSORPTIVITY

Ge ONLY

Ag-Ge LAYER

WAVELENGTH

FIG. 9B

| Ge |
|:---:|
| n-Si |

FIG. 10A

FIG. 10B

Ag          Ge

n-Si

## FIG. 11A

CONVERSION EFFICIENCY

Ag-Ge LAYER

Ge ONLY

WAVELENGTH

## FIG. 11B

Al$_2$O$_3$

n-Si

FIG. 12A

Ag(Al$_2$O$_3$)-Ge LAYER

Ag-Ge LAYER

Ge ONLY

CONVERSION EFFICIENCY

WAVELENGTH

FIG. 12B

n-Si

## FIG. 13A

Ag    Ge

n-Si

## FIG. 13B

Ag    POLY-CRYSTALLIZED Ge

n-Si

## FIG. 13C

ELECTRODE

n-Si

ELECTRODE

## FIG. 13D

n-Si

FIG. 14A

Ag    Si

n-Si

FIG. 14B

Ag    POLY-CRYSTALLIZED Si

n-Si

FIG. 14C

ELECTRODE

n-Si

ELECTRODE

FIG. 14D

n-Si

FIG. 15A

Ag    Al₂O₃    Si

n-Si

FIG. 15B

POLY-CRYSTALLIZED Si

n-Si

FIG. 15C

ELECTRODE

n-Si

ELECTRODE

FIG. 15D

n-Si

p-Si

FIG. 16A

Ag          Si

n-Si

FIG. 16B

Ag          Si      POLY-CRYSTALLIZED Si

FIG. 16C

ELECTRODE    ELECTRODE

ELECTRODE                    ELECTRODE

FIG. 16D

FIG. 17A

FIG. 17B

FIG. 17C

FIG. 17D

n-Si

p-Si

## FIG. 18A

Ag    Ge

n-Si

## FIG. 18B

Ag    POLY-CRYSTALLIZED Si

## FIG. 18C

ELECTRODE    ELECTRODE

ELECTRODE    ELECTRODE

## FIG. 18D

n-Si

p-Si

**FIG. 19A**

Ag    Al$_2$O$_3$    Si

n-Si

**FIG. 19B**

**FIG. 19C**

ELECTRODE    ELECTRODE

ELECTRODE    ELECTRODE

**FIG. 19D**

FIG. 20A

Ag       Al₂O₃       Ge

FIG. 20B

Ag       Al₂O₃       POLY-CRYSTALLIZED Ge

FIG. 20C

ELECTRODE       ELECTRODE

FIG. 20D

FIG. 21A

Ag          Al₂O₃          Si

FIG. 21B

Ag          Al₂O₃          POLY-CRYSTALLIZED Si

FIG. 21C

ELECTRODE          ELECTRODE

FIG. 21D

Europäisches
Patentamt

European
Patent Office

Office européen
des brevets

# EUROPEAN SEARCH REPORT

Application Number

EP 14 18 5107

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/092221 A1 (DE MOURA DIAS MENDES MANUEL JOAO [ES] ET AL) 18 April 2013 (2013-04-18) * paragraph [0073] - paragraph [0077]; figures 1, 5 * * paragraph [0040] - paragraph [0045] * * * * paragraph [0092] * * paragraph [0093] * * paragraph [0094] - paragraph [0095] * * paragraph [0115] * * paragraph [0113] - paragraph [0114] * | 1-14 | INV. H01L31/0352 |
| A | WO 2013/042942 A1 (LG INNOTEK CO LTD [KR]) 28 March 2013 (2013-03-28) * paragraph [0041] * * paragraphs [0077] - [0082] * * paragraphs [0038] - [0040] * * paragraph [0037]; figure 9 * * paragraph [0027] * | 1-14 | |
| A | US 2012/298190 A1 (DUTTA ACHYUT KUMAR [US]) 29 November 2012 (2012-11-29) * paragraph [0072] * * paragraph [0076] * * paragraph [0073] * * * * paragraph [0055] * * paragraph [0056]; figure 6c * | 1-14 | TECHNICAL FIELDS SEARCHED (IPC) H01L |
| A | US 2011/278541 A1 (HUANG LUDAN [US] ET AL) 17 November 2011 (2011-11-17) * paragraph [0052] - paragraph [0054] * * paragraph [0073] * * paragraph [0067] * * paragraph [0055] * * paragraph [0044]; figure 1c * | 1-14 | |

-/--

The present search report has been drawn up for all claims

| Place of search | Date of completion of the search | Examiner |
|---|---|---|
| Berlin | 15 January 2015 | Chao, Oscar |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 14 18 5107

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/081683 A1 (MASUNAGA KUMI [JP] ET AL) 4 April 2013 (2013-04-04)<br>* paragraph [0047] - paragraph [0053] *<br>* paragraph [0067] - paragraph [0068]; figure 1 *<br>* paragraph [0071] - paragraph [0073] *<br>----- | 1-14 | |

TECHNICAL FIELDS
SEARCHED       (IPC)

The present search report has been drawn up for all claims

| Place of search | Date of completion of the search | Examiner |
|---|---|---|
| Berlin | 15 January 2015 | Chao, Oscar |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.............................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 14 18 5107

This annex lists the patent family members relating to the patent documents cited in the above-mentioned European search report.
The members are as contained in the European Patent Office EDP file on
The European Patent Office is in no way liable for these particulars which are merely given for the purpose of information.

15-01-2015

| Patent document cited in search report | | Publication date | Patent family member(s) | | Publication date |
|---|---|---|---|---|---|
| US 2013092221 | A1 | 18-04-2013 | NONE | | |
| WO 2013042942 | A1 | 28-03-2013 | CN | 103875083 A | 18-06-2014 |
| | | | KR | 20130031154 A | 28-03-2013 |
| | | | US | 2014230896 A1 | 21-08-2014 |
| | | | WO | 2013042942 A1 | 28-03-2013 |
| US 2012298190 | A1 | 29-11-2012 | NONE | | |
| US 2011278541 | A1 | 17-11-2011 | NONE | | |
| US 2013081683 | A1 | 04-04-2013 | CN | 102918651 A | 06-02-2013 |
| | | | US | 2013081683 A1 | 04-04-2013 |
| | | | WO | 2011125101 A1 | 13-10-2011 |

EPO FORM P0459

For more details about this annex : see Official Journal of the European Patent Office, No. 12/82